## Europäisches Patentamt

## European Patent Office

## Office européen des brevets

(11) Veröffentlichungsnummer: **0 196 413**
**B1**

## EUROPÄISCHE PATENTSCHRIFT

(45) Veröffentlichungstag der Patentschrift:
06.12.89

(21) Anmeldenummer: 86100686.0

(22) Anmeldetag: 23.01.86

(51) Int. Cl.⁴: **H 03 H 7/01**, H 03 H 17/02

(54) Tiefen- oder Höhen-Shelving-Filter.

(30) Priorität: 09.03.85 DE 3508449

(43) Veröffentlichungstag der Anmeldung:
08.10.86 Patentblatt 86/41

(45) Bekanntmachung des Hinweises auf die Patenterteilung:
06.12.89 Patentblatt 89/49

(84) Benannte Vertragsstaaten:
AT DE GB IT NL

(56) Entgegenhaltungen:
JOURNAL OF THE AUDIO ENGINEERING SOCIETY, Band 31, Nr. 11, November 1983, Seiten 826-841, New York, US; J.A. MOORER: "The manifold joys of conformal mapping: applications to digital filtering in the studio"
ELECTRONICS LETTERS, Band 8, Nr. 6, 23. März 1972, Seiten 157-158, Hitchin, GB; J.A. MILLER: "Maximally flat nonrecursive digital filters"

(73) Patentinhaber: ANT Nachrichtentechnik GmbH, Gerberstrasse 33, D-7150 Backnang (DE)

(72) Erfinder: Baudisch, Werner, Dipl.- Ing., Im Windhuck 30, D-3341 Denkte 1 (DE)
Erfinder: Göckler, Heinz, Dipl.- Ing., Elbinger Strasse 52, D-7150 Backnang (DE)
Erfinder: Masslich, Roland, Dipl.- Ing., Heinrichstrasse 37, D-3300 Braunschweig (DE)

(74) Vertreter: Wiechmann, Manfred, Dipl.- Ing., ANT Nachrichtentechnik GmbH Gerberstrasse 33 Postfach 11 20, D-7150 Backnang (DE)

**Beschreibung**

Shelving-Filter dienen zur Anhebung oder Absenkung der tief- oder hochfrequenten Spektralanteile eines Signals. Dabei sollen die nicht zu bewertenden (hoch- bzw. tieffrequenten) Spektralanteile das Shelving-Filter möglichst unbeeinflußt passieren. Man spricht daher von Tiefen- bzw. Höhen-Shelving. Als weitere Bezeichnung für diese Dämpfungsentzerrer kursiert der Ausdruck "Kuhschwanz"-Filter.

Nicht einmal für analoge Shelving-Filter liegen einheitliche Spezifikationen der Wunschbetragsverläufe über der Frequenz vor. So werden in der Literatur für Tiefen- und Höhen-Shelving Filterfunktionen 1. und 2. Ordnung verwendet, wobei im Fall 2. Ordnung die Flankensteilheit variiert werden kann.

Im AES Preprint, New York, 30.10. bis 02.11.1981, ist von Sakamoto et al ein Shelving-Filter 1. Ordnung angegeben, dessen Flankensteilheit aber nicht veränderbar ist.

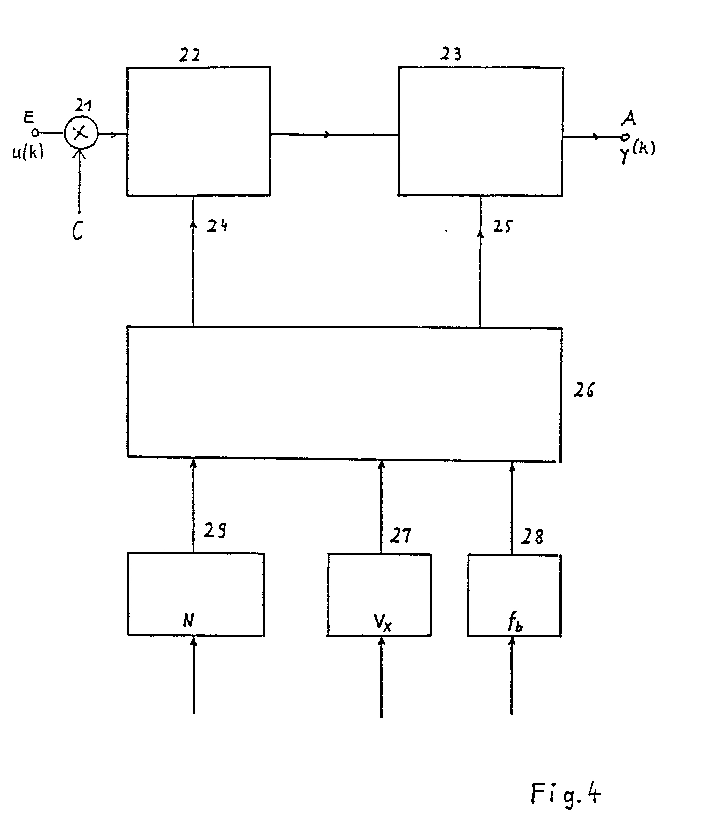

Mc Nally gibt in BBC Research Dept. Report 1981/10 und in J. Audio Eng. Soc. 27 (Oktober 1979) 10, Seiten 793 bis 803, ein Shelving-Filter 2. Ordnung an, dessen Flankensteilheit veränderbar ist; die Änderung der Flankensteilheit wird unter Beibehaltung der 2. Ordnung durch Verschiebung der Pole und Nullstellen des Filters bewirkt, was zur Folge hat, daß der Frequenzgang bei den Frequenzen $f = 0$, bei der Hälfte $f_A/2$ der Abtastfrequenz $f_A$ oder bei $f = \infty$ nicht mehr maximal flach verläuft; außerdem weist der Frequenzgang in Flankennähe über- oder Unterschwinger auf (vgl. J. Audio Eng. Soc., Seite 799, Fig. 4f).

Es ist Aufgabe der Erfindung, ein analoges, insbesondere aber ein digitales Tiefen- oder Höhen-Shelving-Filter zu schaffen mit einem Frequenzgang (Filtercharakteristik) des Betrages der Übertragungsfunktion (Transmittanz), dessen Flankensteilheit veränderbar ist, wobei aber trotz dieser Veränderbarkeit der Verlauf der Filtercharakteristik bei den Frequenzen $f = 0$ und bei $f = \infty$ (analoges Shelving) oder $f = f_A/2$ (mit $f_A$ = Abtastfrequenz) (digitales Shelving) maximal flach bleibt und Über- und Unterschwinger vermieden sind; die maximale Flachheit soll also unabhängig von der gewählten Flankensteilheit gewährleistet sein. Diese Aufgabe wird gelöst durch die Filter mit den Merkmalen der Ansprüche 1 (analog) oder 2 (digital). Vorteilhafte Weiterbildungen sind in den Unteransprüchen angegeben.

Die Festlegung der Nullstellen $w_{on}$ und Pole $w_{\infty n}$ nach Anspruch 1 bewirkt, daß in jedem der veränderbaren Zustände (Filtergrade) des Filters die ersten $N - 1$ Ableitungen

$$\frac{d^n |S_{21}\,(jf)|}{df^n}$$

$$\text{bzw.} \quad \frac{d^n |S_{21}\,(jv)|}{dv^n}$$

($n = 1, 2, ..., N - 1$) des Betrags der Übertragungsfunktion $S_{21}$ (jf) bzw. $S_{21}$ (jv) nach der Frequenz bei den Frequenzen $f = 0$ und $f = \infty$ verschwinden (zur Erfüllung der Forderung nach maximal flachem Verlauf).

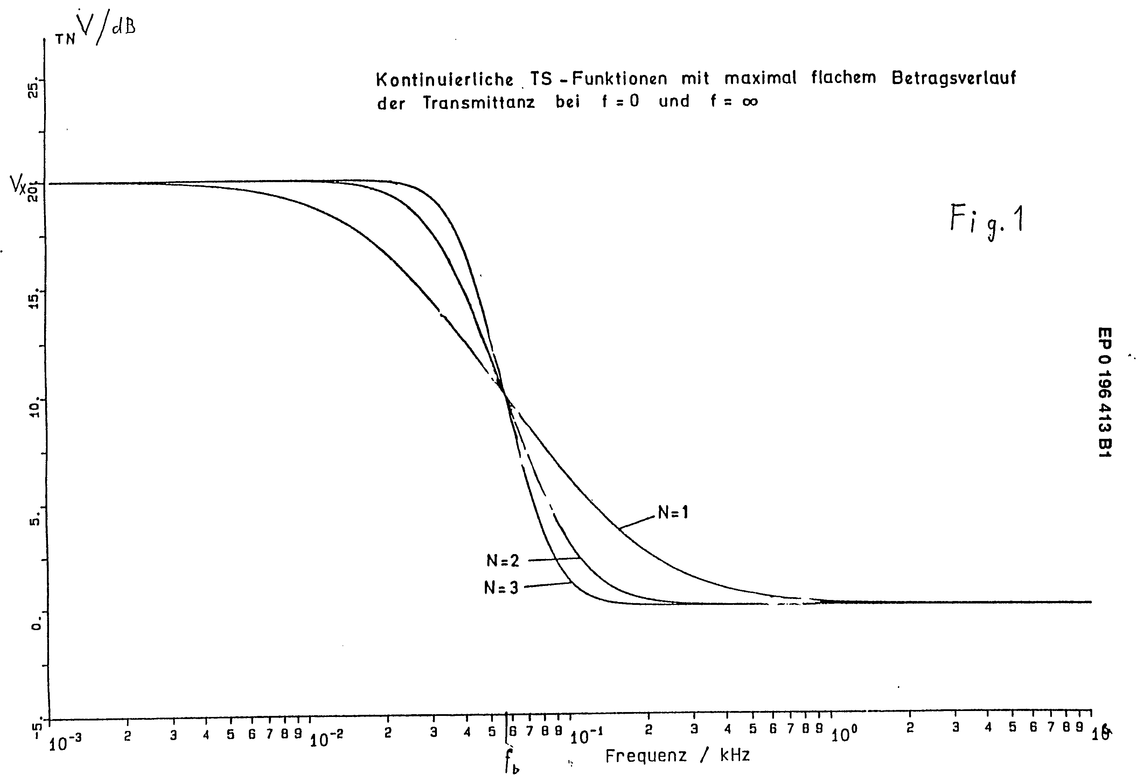

Als Beispiele für Filter nach Patentanspruch 1 werden im folgenden die Transmittanzen und Parameter (Null- und Polstellen) für ein analoges Tiefen-Shelving-Filter mit Anhebung vom maximalen Grad (Ordnung) $N = 3$ angegeben, das auf $N = 2$ und $N = 1$ umschaltbar ist und bei dem gegenüber einem Bezugswert bei hohen Frequenzen eine Anhebung des Betrages der Transmittanz bei tiefen Frequenzen vorgesehen ist. Dabei bedeuten die vorangestellten Indizes 1, 2, 3 diese wählbaren Filtergrade, der vorangestellte Index T bedeutet Tiefen-Shelving, die Nullstellen im kontinuierlichen w-Bereich sind mit $w_o$ und die Polstellen mit $w_\infty$ bezeichnet. Die Verstärkung V (in dB) hängt mit der Transmittanz wie folgt zusammen: $V = 20 \log |S_{21}|$. Im Folgenden wird vorausgesetzt, daß die Bezugsverstärkung (Minimalverstärkung) gleich Null dB und demgegenüber die Anhebung (in diesem speziellen Fall zugleich Maximalverstärkung) gleich $V_x$ [dB] ist (vgl. Figur 1).

Als Transmittanzen mit maximal flachem Verlauf über der Frequenz f ergeben sich im kontinuierlichen w-Bereich für die Grade 1 bis 3:

$$_{T1}S_{21}\,(w) = \frac{w + r_o}{w + r_\infty} \tag{Gl. 11}$$

$$_{T2}S_{21}\,(w) = \frac{w^2 + \sqrt{2}r_o w + r^2_o}{w^2 + \sqrt{2}r_\infty w + r_\infty^2} \tag{Gl. 12}$$

$$_{T3}S_{21}\,(w) = \frac{w^3 + 2r_o w^2 + 2r^2_o w + r^3_o}{w^3 + 2r_\infty w^2 + 2r^2_\infty w + r^3_\infty} \tag{Gl. 13}$$

mit $w = jv = jf/f_b$ ($f_b$: Bezugsfrequenz, bei welcher die Verstärkung V die Hälfte ihres Extremalwertes $V_x$ erreicht bzw. bei der gilt: $|S_{21}\,(jf_b)| = \sqrt{|S_{21x}|}$). Diese Transmittanzen mit maximal flachem Betragsverlauf bei $v = 0$ und $v = \infty$ weisen mit $r_o = 1/r_\infty = \sqrt[N]{10^{V_x/40}}$ folgende Null- und Polstellen auf:

**Für N = 1 gilt:**

$$w_0 = -r_0 = r_0 \cos \theta_1 \tag{Gl. 14a}$$

$$w_\infty = -r_\infty = 1/w_0 = r_\infty \cos \theta_1 \tag{Gl. 14b}$$

jeweils mit $\theta_1 = 180°$

**Für N = 2 gilt:**

$$w_{01,2} = r_0 \frac{-1 \pm j}{\sqrt{2}} = (\cos \theta_2 \pm j \cdot \sin \theta_2) \sqrt{10^{Vx/40}} \tag{Gl. 15a}$$

$$w_{\infty 1,2} = r_\infty \frac{-1 \pm j}{\sqrt{2}} = \frac{(\cos \theta_2 \pm j \cdot \sin \theta_2)}{\sqrt{10^{Vx/40}}} = \frac{1}{w^*_{01,2}} \tag{Gl.15b}$$

jeweils mit $\theta_2 = 135°$

**Für N = 3 gilt:**

$$w_{01} = -r_0 = -\sqrt[3]{10^V{}_x/40} \tag{Gl.16a}$$

$$w_{02,3} = r_0 \frac{-1 \pm j\sqrt{3}}{2} = (\cos \theta_3 \pm j \sin \theta_3) \sqrt[3]{10^V{}_x/40} \tag{Gl. 16b}$$

$$w_{\infty 1} = -r_\infty = 1/w_{01} = -1/\sqrt[3]{10^V{}_x/40}$$

$$w_{\infty 2,3} = r_\infty \frac{1 \pm j\sqrt{3}}{2} = \frac{(\cos \theta_3 \pm j \sin \theta_3)}{\sqrt[3]{10^V{}_x/40}} = \frac{1}{w^*_{02,3}}$$

jeweils mit $\theta_3 = 120°$

Offenbar liegen die Pole und Nullstellen der Transmittanzen für Tiefen-Shelving mit maximal flachem Verlauf wechselweise spiegelbildlich zum Einheitskreis der kontinuierlichen w-Ebene. Die Pole und Nullstellen unterscheiden sich demnach nur im Betrag, nicht aber im Phasenwinkel $\theta_N$ voneinander.

Zur Veranschaulichung der erzielten Filtercharakteristiken sind in Figur 1 die Beträge der maximal flachen Tiefen-Shelving-Funktion 1., 2. und 3. Grades aufgetragen. Aus dieser Darstellung ist ersichtlich, wie die Flankensteilheit bei der Bezugsfrequenz $f_b$ allein durch Variieren des Grades N geändert werden kann, ohne daß es zu Über- oder Unterschwingern kommt.

Mit der Abkürzung

$$A = 10^{Vx/20} \tag{Gl. 18}$$

erhält man als weiteres Beispiel die Transmittanzen für das Höhen-Shelving (vorangestellter Index H) bei gleicher Extremalverstärkung $V_x$:

$$_{H1}S_{21}(w) = A \frac{w + A^{-1/2}}{w + A^{1/2}} \tag{Gl. 19}$$

$$_{H2}S_{21}(w) = A \frac{w^2 + \sqrt{2} A^{-1/4} w + A^{-1/2}}{w^2 + \sqrt{2} A^{1/4} w + A^{-1/2}} \tag{Gl. 20}$$

$$_{H3}S_{21}(w) = A \frac{w^3 + 2A^{-1/6} w^2 + 2A^{-1/3} w + A^{-1/2}}{w^3 + 2A^{1/6} w^2 + 2A^{1/3} w + A^{1/2}} \tag{Gl. 21}$$

In Ergänzung wird noch der Betrag der Transmittanz der maximal flachen Shelving-Funktionen in einheitlicher Form für beliebige N angegeben:

$$|_{T}NS_{21}(jv)| = \sqrt{\frac{v^{2N}+r_0^{2N}}{v^{2N}+r_\infty^{2N}}} = \sqrt{\frac{v^{2N}+A}{v^{2N}+1/A}} \tag{Gl. 24}$$

$$|_{H}NS_{21}(jv)| = A\sqrt{\frac{v^{2N}+1/A}{v^{2N}+A}} \tag{Gl. 25}$$

Aus dem einstellbaren analogen Shelving-Filter, wie in den Gleichungen 11 bis 21 angegeben, läßt sich mit Hilfe der bilinearen oder einer äquivalenten Transformation ein digitales rekursives Shelving-Filter ableiten, bei dem die Flankensteilheit ebenfalls nur durch Variieren des Filtergrades N einstellbar ist, wobei die maximale Flachheit einerseits bei der Frequenz $f = 0$ und andererseits bei der Frequenz $f = f_A/2$ (anstelle der Frequenz $f = \infty$ beim analogen Filter) erhalten bleibt.

Der Entwurf des digitalen Shelving-Filters mit Hilfe der bilinearen Transformation erfolgt mit den beiden Transformationspaaren:

$$w = {}_{T}C_B\frac{z-1}{z+1} \tag{Gl. 1a}$$

(T Bedeutet: Tiefen-Shelving
B bedeutet: Bilineare Transformation)

$$z = \frac{{}_{T}C_B+w}{{}_{T}C_B-w} \tag{Gl. 1b}$$

und

$$w = {}_{H}C_B\frac{z+1}{z-1} \tag{Gl. 2a}$$

(H bedeutet: Höhen-Shelving)

$$z = \frac{w+{}_{H}C_B}{w-{}_{H}C_B} \tag{Gl. 2b}$$

Dabei ist die Transformationskonstante $C_B$ jeweils durch die Bezugsfrequenz $f_b$ festgelegt:

$$_{T}C_B = \cot \pi \frac{{}_{T}f_b}{f_A} \tag{Gl. 26a}$$

$f_b$: Bezugsfrequenz, wo $V = V_x/2$ gilt

$f_a$: Abtastfrequenz

$$_{H}C_B = \tan \pi \frac{{}_{H}f_b}{f_A} \tag{Gl. 26b}$$

Die gewünschten (bilinearen) Transmittanzen $_{B}{}_{T}NS_{21}(z)$ (mit N = 1, 2, 3: Filtergrad) eines digitalen Tiefen-Shelving-Filters mit veränderbarem Filtergrad erhält man aus den normierten Funktionen $TN^{S}21^{(w)}$ (Gln. 11 bis 13) des analogen Tiefen-Shelving-Filters durch Einsetzen von Gl. (1) bzw. Gl. (2) mit Gl. (26a) bzw. mit Gl. (26b) folgendermaßen:

EP 0 196 413 B1

Dabei wird eine Kaskadenschaltung eines Blockes ersten Grades und eines Blockes zweiten Grades angenommen. Der Block ersten Grades ist Bestandteil des maximal flachen Tiefen-Shelving-Filters, wenn es als Filter ersten oder dritten Grades betrieben wird; der Block zweiten Grades ist Bestandteil des Filters, wenn es als Filter zweiten oder dritten Grades betrieben wird. Berechnung der beiden Blöcke:

Block 1. Grades

Mit $w_0 = w_0^* = -r_0 = 1/w_\infty = -1/r_\infty < 0$ (Gl. 14) gilt für die Transmittanz eines mit der bilinearen Transformation entworfenen Blocks 1. Grades eines Tiefen-Shelving-Filters 1. bzw. 3. Ordnung in Kaskadenschaltung:

$N = 1$:

(Gl. 27)

$$T_1{}^B S_{21}(z) = T_1{}^B C \frac{z + {}^B_T a_{01}}{z + {}^B_T b_{01}}$$

woraus mit Gl. (26a) und $\Omega_b = 2\pi {}^T f_b/f_A$ folgt:

(Gl. 28a)

$$\text{Nullstelle: } {}^B_T z_0 = \frac{1 + \cos\Omega_b - r_0 \sin\Omega_b}{1 + \cos\Omega_b + r_0 \sin\Omega_b}$$

(Gl. 28b)

$$\text{Pol: } {}^B_T z_\infty = \frac{1 + \cos\Omega_b - r_\infty \sin\Omega_b}{1 + \cos\Omega_b + r_\infty \sin\Omega_b}$$

$$\text{Koeffizeinten: } {}^B_T a_{01} = -{}^B_T z_0$$

(Gl. 28c)

$${}^B_T b_{01} = -{}^B_T z_\infty$$

$${}^B_{T_1} C = r_0 \frac{1 + \cos\Omega_b + r_0 \sin\Omega_b}{r_0(1 + \cos\Omega_b) + \sin\Omega_b}$$

Für die Transmittanz eines mit der bilinearen Transformation entworfenen Blocks 1. Grades eines maximal flachen Höhen-Shelving-Filters 1. bzw. 3. Ordnung gilt ebenfalls mit $w_0 = w_0^* = -r_0 = 1/w_\infty = -1/r_\infty < 0$

$${}^B_{H_1} S_{21}(z) = {}^B_{H_1} C \frac{z + {}^B_H a_{01}}{z + {}^B_H b_{01}}$$

(Gl. 29)

woraus aufgrund des Zusammenhangs zwischen Höhen- und Tiefen-Shelving-Funktionen mit Gl. (26b), wobei $\Omega_b = 2\pi {}^H f_b/f_A$ ist, und Gl. 28 folgt:

(Gl. 30a)

$$\text{Nullstelle: } {}^B_H z_0 = {}^B_T z_\infty$$

$$\text{Pol: } {}^B_H z_\infty = {}^B_T z_0$$

(Gl. 30b)

$$\text{Koeffizienten: } {}^B_H a_{01} = -{}^B_H z_0$$

$${}^B_H b_{01} = -{}^B_H z_\infty$$

(Gl. 30c)

$${}^B_{H_1} C = \frac{r_0^2}{{}^B_{T_1} C}$$

In diese Beziehungen ist (wie vorne erwähnt) $r_0 = 1/r_\infty = A^{1/2N} = 10^{Vx/40N}$ zu setzen, wobei $N \in \{1,3\}$ den Filtergrad angibt.

Block 2. Grades

Mit $r_0 = 1/r_\infty > 0$ und $\theta_2 = 135°$ für $N = 2$ bzw. $\theta_3 = 120°$ für $N = 3$ gilt für die Transmittanz eines mit der bilinearen Transformation entworfenen Blocks 2. Grades eines maximal flachen Tiefen-Shelving-Filters 2. bzw. 3. Ordnung in Kaskadenschaltung

5

$$^{B}_{T2}S_{21}(z) = {^{B}_{T2}}C \frac{z^2 + {^{B}_{Ta12}}z + {^{B}_{Ta02}}}{z^2 + {^{B}_{Tb12}}z + {^{B}_{Tb02}}} \qquad \text{(Gl. 31)}$$

woraus mit Gl. 26a und $\Omega_b = 2\pi^T f_b/f_A$ folgt:

$$\text{Nullstellen: } {^{B}_{T}}z_{o1,2} = \frac{1 + \cos\Omega_b - r^2_o(1-\cos\Omega_b) \pm j2r_o\sin\theta_N\sin\Omega_b}{1 + \cos\Omega_b + r^2_o(1-\cos\Omega_b) - 2r_o\cos\theta_N\sin\Omega_b} \qquad \text{(Gl. 32a)}$$

$$\text{Pole: } {^{B}_{T}}z_{\infty1,2} = \frac{1 + \cos\Omega_b - r^2_\infty(1-\cos\Omega_b) \pm j2r\sin\theta_N\sin\Omega_b}{1 + \cos\Omega_b + r^2_\infty(1-\cos\Omega_b) - 2r_\infty\cos\theta_N\sin\Omega_b} \qquad \text{(Gl. 32b)}$$

$$\text{Koeffizienten: } {^{B}_{T}}a_{12} = -2 \frac{1 + \cos\Omega_b - r^2_o(1-\cos\Omega_b)}{1 + \cos\Omega_b + r^2_o(1-\cos\Omega_b) - 2r_o\cos\theta_N\sin\Omega_b} \qquad \text{(Gl. 32c)}$$

$$^{B}_{T}a_{02} = \frac{1 + \cos\Omega_b + r^2_o(1-\cos\Omega_b) + 2r_o\cos\theta_N\sin\Omega_b}{1 + \cos\Omega_b + r^2_o(1-\cos\Omega_b) - 2r_o\cos\theta_N\sin\Omega_b}$$

$$^{B}_{T}b_{12} = -2 \frac{1 + \cos\Omega_b - r^2_\infty(1-\cos\Omega_b)}{1 + \cos\Omega_b + r^2_\infty(1-\cos\Omega_b) - 2r_\infty\cos\theta_N\sin\Omega_b}$$

$$^{B}_{T}b_{02} = \frac{1 + \cos\Omega_b + r^2_\infty(1-\cos\Omega_b) + 2r_\infty\cos\theta_N\sin\Omega_b}{1 + \cos\Omega_b + r^2_\infty(1-\cos\Omega_b) - 2r_\infty\cos\theta_N\sin\Omega_b}$$

$$^{B}_{T2}C = r^2_o \frac{1 + \cos\Omega_b + r^2_o(1-\cos\Omega_b) - 2r_o\cos\theta_N\sin\Omega_b}{r^2_o(1+\cos\Omega_b) + 1 - \cos\Omega_b - 2r_o\cos\theta_N\sin\Omega_b}$$

Für die Transmittanz eines mit der bilinearen Transformation entworfenen Blocks 2. Grades eines maximal flachen Höhen-Shelving-Filters 2. bzw. 3. Ordnung gilt ebenfalls mit $r_o = 1/r_\infty > 0$ und $\theta_2 = 135°$ für $N = 2$ bzw. $\theta_3 = 120°$ für $N = 3$.

$$^{B}_{H2}S_{21}(z) = {^{B}_{H2}}C \frac{z^2 + {^{B}_{Ha12}}z + {^{B}_{Ha02}}}{z^2 + {^{B}_{Hb12}}z + {^{B}_{Hb02}}} \qquad \text{(Gl. 33)}$$

woraus aufgrund des Zusammenhangs zwischen Höhen- und Tiefen-Shelving-Funktionen mit Gl. (26b) mit der Abkürzung $\Omega_b = 2\pi^H f_b/f_A$ und Gl. (32) folgt:

$$\text{Nullstellen: } {^{B}_{H}}z_{o1,2} = {^{B}_{T}}z^*_{\infty1,2} \text{ (Der Stern bedeutet: konjugiert komplex)} \qquad \text{(Gl. 34a)}$$

$$\text{Pole: } {^{B}_{H}}z_{\infty1,2} = {^{B}_{T}}z^*_{o1,2} \qquad \text{(Gl. 34b)}$$

$$\text{Koeffizienten: } {^{B}_{H}}a_{12} = {^{B}_{T}}b_{12}$$

$$^{B}_{H}a_{02} = {^{B}_{T}}b_{02}$$

$$^{B}_{H}b_{12} = {^{B}_{T}}a_{12}$$

$$^{B}_{H}b_{02} = {^{B}_{T}}a_{02} \qquad \text{(Gl. 34c)}$$

$$^{B}_{H2}C = \frac{r^4_o}{{^{B}_{T2}}C}$$

In diese Beziehungen ist $r_o = 1/r_\infty = A^{1/2N} = 10^{Vx/40N}$ zu setzen, wobei $N \in \{2,3\}$ den Filtergrad angibt. Offenbar ist die mit der bilinearen Transformation erhaltene Transmittanz einer maximal flachen Shelving-Funktion 3. Ordnung gegeben durch

$$^{B}_3S_{21}(z) = {}^{B}_2S_{21}(z) \cdot {}^{B}_1S_{21}(z) \tag{Gl. 35}$$

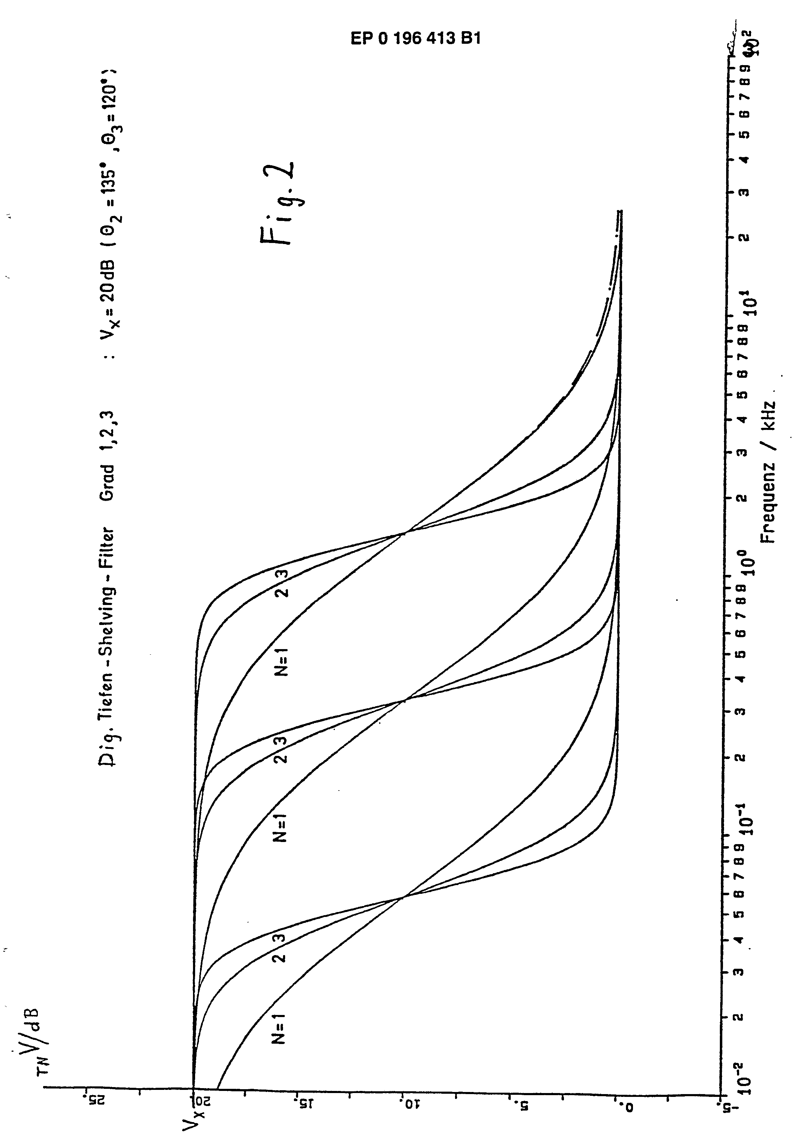

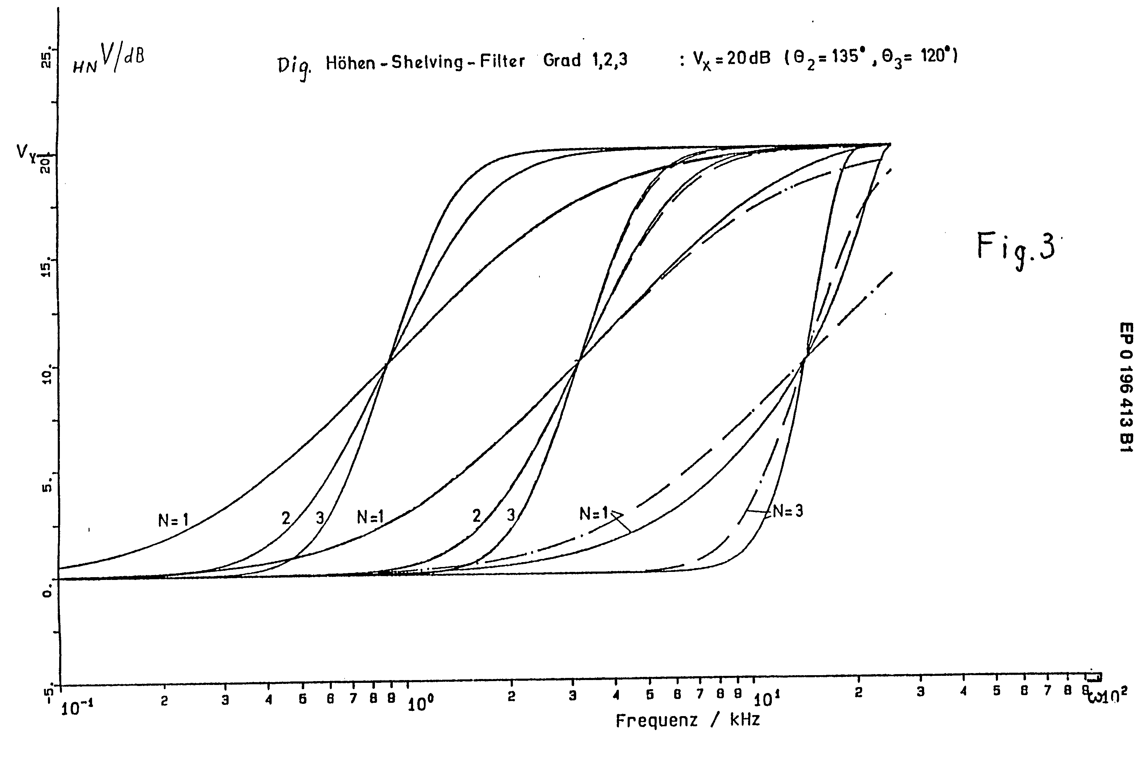

In den Figuren 2 und 3 sind verschiedene mit der bilinearen Transformation erhaltene Frequenzgänge der Verstärkung von maximal flachen Shelving-Funktionen 1., 2. und 3. Ordnung für unterschiedliche Bezugsfrequenzen $f_b$ dargestellt.

Bemerkenswert ist dabei, daß insbesondere beim Höhen-Shelving und dort insbesondere zunehmend bei höheren Bezugsfrequenzen die digitalen, nach bilinearer Transformation erhaltenen Filter insofern besser sind als die analogen Filter, deren entsprechende Kennlinien ebenfalls, jedoch mit unterbrochenen Linien eingezeichnet sind, als die digitalen Kennlinien besser der idealen Sprungfunktion angenähert sind, bei welcher die Verstärkung V bei der Bezugsfrequenz $f_b$ vom Wert 0 auf 20 dB springt.

Davon abgesehen ermöglichen alle erfindungsgemäßen (analogen und digitalen) Shelving-Filter unter Berücksichtigung der Nebenbedingung, daß der Verlauf der Filtercharakteristik bei der Frequenz $f = 0$ und bei den Frequenzen $f = \infty$ bzw. $f = f_A/2$ maximal flach sein soll und daß ein Über- und Unterschwingen vermieden sein soll, eine sehr gute Annäherung an die ideale Sprungfunktion bei gleichzeitiger Einstellbarkeit der Flankensteilheit allein durch Wahl des Filtergrades.

In Fig. 4 ist ein Prinzip-Blockschaltbild für ein digitales Filter in Kaskadenform nach der Erfindung angegeben. Es erhält an einem Eingang E Eingangssignale u(k) (im Takt der Abtastfrequenz $f_A$) die in einem Multiplizierer 21 mit einer Konstanten C multipliziert werden. Das erhaltene Produkt gelangt in einen Block erster Ordnung 22 und von dort in einen nachgeschalteten Block zweiter Ordnung 23, der am Ausgang A Ausgangssignale y(k) liefert. Die Blöcke bilden Filterglieder mit je einem Koeffizienteneingang 24 bzw. 25 zur Zuführung von Koeffizientensignalen von einer selbsttätigen Steuerschaltung 26 in Gestalt eines Koeffizientenspeichers oder -rechners, dem je ein Einsteller 27, 28 für die Extremalverstärkung $V_x$ bzw. die Bezugsfrequenz $f_b$ sowie Einstellmittel 29 für die Flankensteilheit zugeordnet sind. Mit diesem Einstellmittel 29 bzw. den Einstellern 27, 28 kann der Koeffizientenspeicher oder -rechner so beeinflußt werden, daß er unterschiedliche Koeffizienten (wie in Anspruch 3 angegeben) an die Blöcke 22, 23 abgibt.

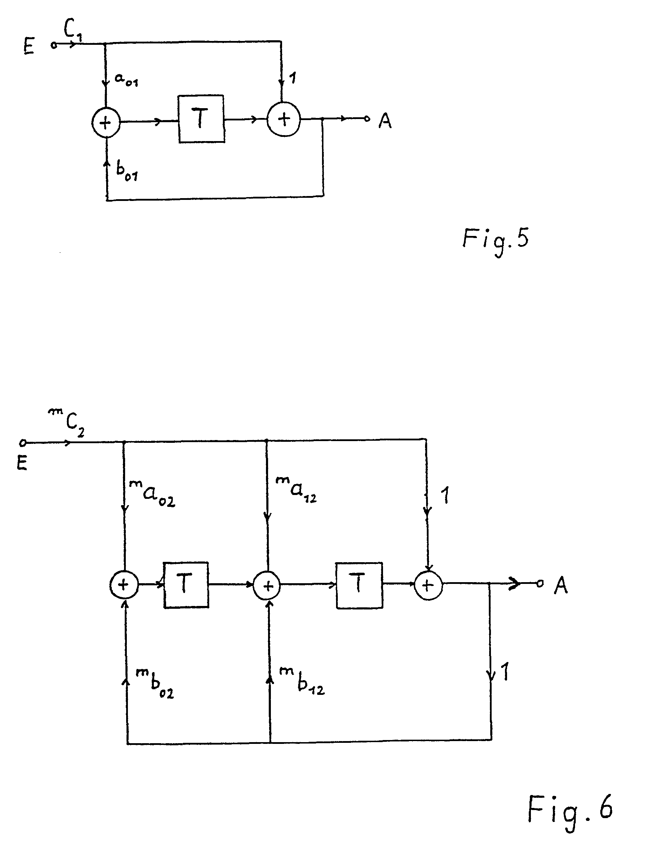

Fig. 5 zeigt ein Prinzipbeispiel für den Block erster Ordnung und

Fig. 6 ein Prinzipbeispiel für den Block zweiter Ordnung in der ersten kanonischen Form; dabei ist mit T jeweils ein Verzögerungsglied mit einer Verzögerung um eine Abtastperiode bezeichnet; die angegebenen Koeffizienten entsprechen denen in Anspruch 3.

**Patentansprüche**

1. Analoges Shelving-Filter vom Grad N mit einstellbarer Flankensteilheit, mit einer größten erzielbaren Überhöhung bzw. Absenkung $\pm V_x$ in dB

- bei der Frequenz $f = 0$ im Falle des Tiefenshelving,
- bei der Frequenz $f \rightarrow \infty$ im Falle des Höhenshelving, mit der halben größten erzielbaren Überhöhung bzw. Absenkung $\pm V_x/2$ bei einer im Flankenbereich liegenden Bezugsfrequenz $f_b$ und ohne Überhöhung bzw. Absenkung

- bei der Frequenz $f \rightarrow \infty$ im Falle des Tiefenshelving,
- bei der Frequenz $f = 0$ im Falle des Höhenshelving, dessen Übertragungsfunktion (Transmittanz) im analogen (kontinuierlichen) w-Bereich folgende Form hat:

$$S_{21}(w) = C \prod_{n=1}^{N} \frac{w - w_{on}}{w - w_{\infty n}}$$

mit $w = jv = jf/f_b$ und $w_{on} = $ n-te Nullstelle, $w_{\infty n} = $ n-te Polstelle, *dadurch gekennzeichnet*, daß es zur Einstellung der Flankensteilheit übliche Einstellmittel zur Änderung des Grades N aufweist und daß bei jedem eingestellten Grad N für die Parameter

$$w_{on} = r_0 (\cos \theta_n + j \sin \theta_n)$$

$$w_{\infty n} = r_\infty (\cos \theta_n + j \sin \theta_n)$$

der Übertragungsfunktion $S_{21}(w)$ gilt:

$$\theta_n = (N + 2n - 1) \, 90°/N$$

und im Falle des Tiefenshelving

$$r_0 = 1/r_\infty = \sqrt[N]{10^{V_x/40}}$$

$$C = 1$$

oder im Falle des Höhenshelving

$$r_\infty = 1/r_0 = \sqrt[N]{10^{Vx/40}}$$

$$C = 10^{Vx/20} = r_\infty^{2N}.$$

2. Digitales Rekursiv-Shelving-Filter mit einstellbarer Flankensteilheit, mit einem Filterglied mit Filtersignaleingang und ausgang sowie Koeffizienteneingang zur Zuführung von Koeffizientensignalen von einer selbsttätigen Steuerschaltung für zu filternde Signale mit einer Abtastfrequenz $f_A$ wobei die Koeffizienten abgespeichert und/oder in der Steuerschaltung rechnerisch von abgespeicherten und/oder eingebbaren Werten ableitbar sind, *dadurch gekennzeichnet*, daß es aus dem Filter nach Anspruch 1 durch bilineare oder eine äquivalente Transformation abgeleitet ist unter Zugrundelegung der für das Filter nach Anspruch 1 geltenden Nullstellen- und Pol-Koordinaten $r_0$, $r_\infty$, $\theta_n$ und der Konstante C, wobei es wiederum zur Einstellung der Flankensteilheit übliche Einstellmittel zur Änderung des Grades N aufweist.

3. Bilinear transformiertes Filter nach Anspruch 2 in Kaskadenform, wobei für ungerade Grade N der reelle Pol zusammen mit der reellen Nullstelle ($\theta_n = 180°$) durch einen Block 1. Grades mit einer Teiltransmittanz

$$_1S_{21}(z) = C_1 \frac{z + a_{01}}{z + b_{01}}$$

realisiert ist und komplexe Pole und Nullstellen jeweils zusammengefaßt mit dem zugehörigen konjugiert komplexen Pol bzw. der konjugiert komplexen Nullstelle durch Blöcke 2. Grades mit einer Teiltransmittanz

$$^m_2S_{21}(z) = {}^mC_2 \frac{z^2 + {}^ma_{12}z + {}^ma_{02}}{z^2 + {}^mb_{12}z + {}^mb_{02}}$$

realisiert sind entsprechend einer resultierenden Transmittanz des Shelving-Filters

$$S_{21}(z) = C \cdot \prod_{m=1}^{\frac{N}{2}} {}^m_2S_{21}(z) \text{ für N gerade}$$

bzw.

$$S_{21}(z) = C \cdot {}_1S_{21}(z) \cdot \prod_{m=1}^{\frac{N-1}{2}} {}^m_2S_{21}(z) \text{ für N ungerade}$$

wobei die Anzahl M der Blöcke 2. Grades gegeben ist durch M = N/2 (N gerade) bzw. M = (N - 1)/2 (N ungerade), *gekennzeichnet durch* die Parameter von Anspruch 1 und folgende Koeffizienten mit $\Omega_b = 2\pi f_b/f_A$ für den Block 1. Grades, falls N ungerade:

$$a_{01} = \frac{1 + \cos\Omega_b - r_0 \sin\Omega_b}{1 + \cos\Omega_b + r_0 \sin\Omega_b}$$

$$b_{01} = \frac{1 + \cos\Omega_b - r_\infty \sin\Omega_b}{1 + \cos\Omega_b + r_\infty \sin\Omega_b}$$

$$C_1 = \frac{1 + \cos\Omega_b + r_0 \sin\Omega_b}{1 + \cos\Omega_b + r_\infty \sin\Omega_b}$$

und für die M Blöcke 2. Grades:

$$^m a_{12} = -2 \frac{1+\cos\Omega_b - r^2_o(1-\cos\Omega_b)}{1+\cos\Omega_b + r^2_o(1-\cos\Omega_b) - 2r_o\cos\theta_n\sin\Omega_b}$$

$$^m a_{02} = \frac{1+\cos\Omega_b + r^2_o(1-\cos\Omega_b) + 2r_o\cos\theta_n\sin\Omega_b}{1+\cos\Omega_b + r^2_o(1-\cos\Omega_b) - 2r_o\cos\theta_n\sin\Omega_b}$$

$$^m b_{12} = -2 \frac{1+\cos\Omega_b - r^2_\infty(1-\cos\Omega_b)}{1+\cos\Omega_b + r^2_\infty(1-\cos\Omega_b) - 2r_\infty\cos\theta_n\sin\Omega_b}$$

$$^m b_{02} = \frac{1+\cos\Omega_b + r^2_\infty(1-\cos\Omega_b) + 2r_\infty\cos\theta_n\sin\Omega_b}{1+\cos\Omega_b + r^2_\infty(1-\cos\Omega_b) - 2r_\infty\cos\theta_n\sin\Omega_b}$$

$$^m C_2 = \frac{1+\cos\Omega_b + r^2_o(1-\cos\Omega_b) - 2r_o\cos\theta_n\sin\Omega_b}{1+\cos\Omega_b + r^2_\infty(1-\cos\Omega_b) - 2r_\infty\cos\theta_n\sin\Omega_b}$$

wobei m = n von 1 bis M läuft.

4. Filter, *dadurch gekennzeichnet*, daß es ebenso aufgebaut ist, wie ein Filter, das bei gleichem Frequenzgang aus einem Filter nach Anspruch 3 nach bekannten Umrechnungsmethoden hergeleitet ist, die zur Strukturänderung z. B. von der Kaskadenform in die direkte Form oder in die Parallelform dienen, wobei die parallelen Teilfilter der Parallelform selbst wieder beliebige Strukturen haben können.

5. Äquivalentes Filter, das insofern zu dem Filter nach Anspruch 3 äquivalent ist, als sich nach Umrechnung des äquivalenten Filters mit Hilfe bekannter Umrechnungsmethoden, die zur Strukturänderung z. B. von der direkten Form oder der Parallelform in die Kaskadenform dienen, das Filter nach Anspruch 3 ergibt, wobei dann, wenn das äquivalente Filter die Parallelform aufweist, die parallelen Teilfilter selbst wieder beliebige Strukturen haben können.

## Claims

1. Analog shelving filter of $N^{th}$ degree with settable slope of flank, with a greatest attainable boost or cut $^\pm V_x$ in dB at the frequency f = 0 in the case of the bass shelving and at the frequency $f\rightarrow\infty$ in the case of the treble shelving, with half the greatest attainable boost or cut $^\pm V_x/2$ at a reference frequency $f_b$ lying in the region of the flank and without boost or cut at the frequency $f\rightarrow\infty$ in the case of the bass shelving and at the frequency f = 0 in the case of the treble shelving, the transfer function (transmittance) of which in the analog (continuous) w-region has the following form:

$$S_{21}(w) = C \prod_{n=1}^{N} \frac{w - w_{on}}{w - w_{\infty n}}$$

wherein w = jv = jf/f_b and $w_{on}$ = $n^{th}$ zero place, $w_{\infty n}$ = $n^{th}$ pole place, *characterised* thereby, that it displays usual setting means for changing the degree N for the setting of the slope of flank and that for each set degree N for the parameters

$$w_{on} = r_o (\cos\theta_n + j\sin\theta_n)$$

$$w_{\infty n} = r_\infty (\cos\theta_n + j\sin\theta_n)$$

of the transfer function $S_{21}(w)$, there applies:

$$\theta_n = (N + 2n - 1)\,90°/N$$

and in the case of the bass shelving

$$r_o = 1/r_\infty = \sqrt[N]{10^{V_x/40}}$$

$$C = 1$$

or in the case of the treble shelving

$$r_\infty = 1/r_0 = {}^N\sqrt{10^{V_x}/40}$$

$$C = 10^{V_x/20} = r_\infty^{2N}.$$

2. Digital recursive shelving filter with settable slope of flank, with a filter member with filter signal input and output as well as co-efficient input for the feed of co-efficient signals from an automatic control circuit for signals to be filtered with a scanning frequency $f_A$, wherein the co-efficients are stored and/or derivable arithmetically in the control circuit from stored and/or enterable values, *characterised* thereby, that it is derived from the filter according to claim 1 by bilinear or an equivalent transformation on the basis of the zero place and pole co-ordinates $r_0$, $r_\infty$ and $\theta_n$, which are valid for the filter according to claim 1 and of the constant C, wherein it again displays usual setting means for changing the degree N for the setting of the slope of flank.

3. Bilinearly transformed filter according to claim 2 in cascade form, wherein the real pole together with the real zero place ($\theta_n = 180°$) for odd degrees N is realised by a block of 1st degree with a partial transmittance

$$_1S_{21}(z) = C_1 \frac{z+a_{01}}{z+b_{01}}$$

and complex poles and zero places, each time combined with the associated conjugate complex pole or the conjugate complex zero place, are realised by blocks of $2^{nd}$ degree with a partial transmittance

$$^m{}_2S_{21}(z) = {}^mC_2 \frac{z^2+{}^ma_{12}z+{}^ma_{02}}{z^2+{}^mb_{12}z+{}^mb_{02}}$$

in accordance with a resultant transmittance of the shelving filter

$$S_{21}(z) = C \cdot \prod_{m=1}^{\frac{N}{2}} {}^m{}_2S_{21}(z) \text{ for even N}$$

or

$$S_{21}(z) = C \cdot {}_1S_{21}(z) \cdot \prod_{m=1}^{\frac{N-1}{2}} {}^m{}_2S_{21}(z) \text{ for odd N,}$$

wherein the number M of the blocks of $2^{nd}$ degree is given by M = N/2 when N is even or by M = (N - 1)/2 when N is odd, *characterised* by the parameters of claim 1 and the following co-efficients with $\Omega_b = 2\pi f_b/f_A$ for the block of $1^{st}$ degree when N is odd

$$a_{01} = \frac{1+\cos\Omega_b-r_0\sin\Omega_b}{1+\cos\Omega_b+r_0\sin\Omega_b}$$

$$b_{01} = \frac{1+\cos\Omega_b-r_\infty\sin\Omega_b}{1+\cos\Omega_b+r_\infty\sin\Omega_b}$$

$$C_1 = \frac{1+\cos\Omega_b+r_0\sin\Omega_b}{1+\cos\Omega_b+r_\infty\sin\Omega_b}$$

and for the blocks of $2^{nd}$ degree

$$^ma_{12} = -2 \frac{1+\cos\Omega_b-r_0^2(1-\cos\Omega_b)}{1+\cos\Omega_b+r_0^2(1-\cos\Omega_b)-2r_0\cos\theta_n\sin\Omega_b}$$

$$m_{a02} = \frac{1+\cos\Omega_b+r^2_o(1-\cos\Omega_b)+2r_o\cos\theta_n\sin\Omega_b}{1+\cos\Omega_b+r^2_o(1-\cos\Omega_b)-2r_o\cos\theta_n\sin\Omega_b}$$

$$m_{b12} = -2\frac{1+\cos\Omega_b-r^2_\infty(1-\cos\Omega_b)}{1+\cos\Omega_b+r^2_\infty(1-\cos\Omega_b)-2r_\infty\cos\theta_n\sin\Omega_b}$$

$$m_{b02} = \frac{1+\cos\Omega_b+r^2_\infty(1-\cos\Omega_b)+2r_\infty\cos\theta_n\sin\Omega_b}{1+\cos\Omega_b+r^2_\infty(1-\cos\Omega_b)-2r_\infty\cos\theta_n\sin\Omega_b}$$

$$m_{C2} = \frac{1+\cos\Omega_b+r^2_o(1-\cos\Omega_b)-2r_o\cos\theta_n\sin\Omega_b}{1+\cos\Omega_b+r^2_\infty(1-\cos\Omega_b)-2r_\infty\cos\theta_n\sin\Omega_b}$$

wherein m = n runs from 1 to M.

4. Filter, *characterised* thereby, that it is built up just like a filter which for the same frequency response is derived from a filter according to claim 3 by known recalculation methods which serve for change in structure, for example from the cascade form into the direct form or into the parallel form, wherein the parallel partial filters of the parallel form can themselves again have any desired structures.

5. Equivalent filter, which is equivalent to the filter according to the claim 3 to the extent the filter according to claim 3 results after recalculation of the equivalent filter with the aid of known recalculation methods which serve for change in structure, for example from the direct form or the parallel form into the cascade form, wherein - when the equivalent filter displays the parallel form - the parallel partial filters can themselves again have any desired structures.

**Revendications**

1. Filtre dit de mise en plateau (shelving filter), analogique, de degré N, à transition inclinée de pente réglable, avec un relevage ou un abaissement maximal réalisable

$\pm V_x$ en dB

- à la fréquence $f = 0$ dans le cas du relèvement des fréquences basses,
- à la fréquence $f \to \infty$ dans le cas de l'abaissement des fréquences hautes, avec la moitié du relevage ou de l'abaissement maximal réalisable $\pm V_x/2$ pour une fréquence de référence $f_b$ située dans la région de la transition et sans relevage ou abaissement

- à la fréquence $f \to \infty$ dans le cas du relèvement des fréquences basses,
- à la fréquence $f = 0$ dans le cas de l'abaissement des fréquences hautes, dont la fonction de transfert (transmittance) dans le domaine analogique (continu) de w possède la forme suivante:

$$S_{21}(w) = C \prod_{n=1}^{N} \frac{w-w_{on}}{w-w_{\infty n}}$$

où $w = jv = jf/f_b$ et $w_{on} = n^{ième}$ zéro, $w_{\infty n} = n^{ième}$ pôle, *caractérisé* en ce qu'il possède des moyens de réglage habituels pour régler la pente de la transition afin de changer le degré N et que pour chaque degré N réglé pour les paramètres

$w_{on} = r_o (\cos\theta_n + j\sin\theta_n)$
$w_{\infty n} = r_\infty (\cos\theta_n + j\sin\theta_n)$

on a la fonction de transfert $S_{21}(w)$:

$\theta_n = (N + 2n - 1)\,90°/N$

et, dans le cas du relèvement des fréquences basses,

$$r_0 = 1/r_\infty = \sqrt[N]{10^{Vx/40}}$$

$$C = 1$$

ou, dans le cas de l'abaissement des fréquences hautes

$$r_\infty = 1/r_0 = \sqrt[N]{10^{V_x/40}}$$

$$C = 10^{Vx/20} = r_\infty^{2N}.$$

2. Filtre dit de mise en plateau (shelving filter), de type récursif, numérique, à transition inclinée de pente réglable, possédant un organe de filtrage présentant une entrée de signal à filtrer et une sortie de signal filtré ainsi qu'une entrée de coefficients pour l'application de signaux de coefficients venant d'un circuit de commande autonome pour des signaux à filtrer avec une fréquence d'échantillonnage $f_A$, les coefficients étant mémorisés et/ou pouvant être dérivés mathématiquement dans le circuit de commande de valeurs mémorisées et/ou pouvant être introduites, *caractérisé* en ce qu'il est dérivé du filtre selon la revendication 1 par transformation bilinéaire ou par une transformation équivalente, sur la base des coordonnées de zéros et de pôles $r_0$, $r_\infty$, $\theta_n$ valables pour le filtre selon la revendication 1 et de la constante C, le filtre présentant de nouveau, pour le réglage de la pente de la transition, des moyens de réglage habituels pour changer le degré N.

3. Filtre ayant subi une transformation bilinéaire, selon la revendication 2, en forme de cascade, dans lequel, pour des degrés M impairs, le pôle réel est réalisé, ensemble avec le zéro réel ($\theta_n = 180°$), par un bloc du premier degré, ayant une transmittance partielle

$$_1S_{21}(z) = C_1 \frac{z+a_{01}}{z+b_{01}}$$

et des pôles et zéros complexes sont réalisés chaque fois, ensemble avec le pôle conjugué complexe associé ou le zéro conjugué complexe associé, par des blocs du deuxième degré, ayant une transmittance partielle

$$^m_2S_{21}(z) = {}^mC_2 \frac{z^2 + {}^ma_{12}z + {}^ma_{02}}{z^2 + {}^mb_{12}z + {}^mb_{02}}$$

ce qui correspond à une transmittance résultante du filtre

$$S_{21}(z) = C \cdot \prod_{m=1}^{\frac{N}{2}} {}^m_2S_{21}(z) \text{ pour N pair}$$

$$S_{21}(z) = C \cdot {}_1S_{21}(z) \cdot \prod_{m=1}^{\frac{N-1}{2}} {}^m_2S_{21}(z) \text{ pour N impair}$$

le nombre M des blocs du deuxième degré étant défini par M = N/2 (N est pair) ou M = (N - 1)/2 (N est impair), *caractérisé par* les paramètres de la revendication 1 et les coefficients suivants, avec $\Omega_b = 2\pi f_b/f_A$ pour le bloc du premier degré, si N est impair:

$$a_{01} = \frac{1+\cos\Omega_b - r_0 \sin\Omega_b}{1+\cos\Omega_b + r_0 \sin\Omega_b}$$

$$b_{01} = \frac{1+\cos\Omega_b - r_\infty \sin\Omega_b}{1+\cos\Omega_b + r_\infty \sin\Omega_b}$$

$$C_1 = \frac{1+\cos\Omega_b + r_0 \sin\Omega_b}{1+\cos\Omega_b + r_\infty \sin\Omega_b}$$

et pour les M blocs du deuxième degré:

$$m_{a12} = -2 \frac{1+\cos\Omega_b - r^2_0(1-\cos\Omega_b)}{1+\cos\Omega_b + r^2_0(1-\cos\Omega_b) - 2r_0\cos\theta_n\sin\Omega_b}$$

$$m_{a02} = \frac{1+\cos\Omega_b + r^2_0(1-\cos\Omega_b) + 2r_0\cos\theta_n\sin\Omega_b}{1+\cos\Omega_b + r^2_0(1-\cos\Omega_b) - 2r_0\cos\theta_n\sin\Omega_b}$$

$$m_{b12} = -2 \frac{1+\cos\Omega_b - r^2_\infty(1-\cos\Omega_b)}{1+\cos\Omega_b + r^2_\infty(1-\cos\Omega_b) - 2r_\infty\cos\theta_n\sin\Omega_b}$$

$$m_{b02} = \frac{1+\cos\Omega_b + r^2_\infty(1-\cos\Omega_b) + 2r_\infty\cos\theta_n\sin\Omega_b}{1+\cos\Omega_b + r^2_\infty(1-\cos\Omega_b) - 2r_\infty\cos\theta_n\sin\Omega_b}$$

$$m_{C2} = \frac{1+\cos\Omega_b + r^2_0(1-\cos\Omega_b) - 2r_0\cos\theta_n\sin\Omega_b}{1+\cos\Omega_b + r^2_\infty(1-\cos\Omega_b) - 2r_\infty\cos\theta_n\sin\Omega_b}$$

où m = n va de 1 à M.

4. Filtre, caractérisé en ce qu'il est construit de la même façon qu'un filtre qui est dérivé, pour la même réponse fréquentielle, d'un filtre selon la revendication 3 d'après des méthodes connues de conversion mathématique, servant au changement de structure, par exemple de la forme en cascade à la forme directe ou à la forme parallèle, les filtres partiels parallèles de la forme parallèle pouvant eux-mêmes avoir toutes structures désirées.

5. Filtre équivalent, lequel est équivalent au filtre selon la revendication 3 dans la mesure où, après conversion du filtre équivalent à l'aide de méthodes de conversion mathématique connues, servant au changement de la structure, par exemple de la forme directe ou de la forme parallèle à la forme en cascade, on obtient le filtre selon la revendication 3, les filtres partiels parallèles, au cas où le filtre équivalent possède la forme parallèle, pouvant eux-mêmes avoir toutes structures désirées.

Kontinuierliche TS - Funktionen mit maximal flachem Betragsverlauf
der Transmittanz bei $f = 0$ und $f = \infty$

Fig. 1

$V/dB$

$TN$

$V_X$

N = 1

N = 2

N = 3

$f_b$   Frequenz / kHz

EP 0 196 413 B1

Dig. Tiefen - Shelving - Filter    Grad 1,2,3    : $V_x = 20$ dB ( $\Theta_2 = 135°$ , $\Theta_3 = 120°$ )

Fig. 2

EP 0 196 413 B1

Frequenz / kHz

Dig. Höhen – Shelving – Filter  Grad 1,2,3      : $V_X = 20\,dB$  $(\Theta_2 = 135°, \Theta_3 = 120°)$

Fig.3

EP 0 196 413 B1

Frequenz / kHz

Fig. 4

Fig.5

Fig.6